Europäisches Patentamt

European Patent Office

Office européen des brevets

(19)

(11) **EP 0 662 163 B1**

(12) **EUROPÄISCHE PATENTSCHRIFT**

(45) Veröffentlichungstag und Bekanntmachung des Hinweises auf die Patenterteilung:
**24.04.1996 Patentblatt 1996/17**

(51) Int Cl.$^6$: **C25D 1/10**

(86) Internationale Anmeldenummer:
**PCT/EP93/02482**

(21) Anmeldenummer: 93920718.9

(22) Anmeldetag: **14.09.1993**

(87) Internationale Veröffentlichungsnummer:
**WO 94/06952 (31.03.1994 Gazette 1994/08)**

(54) **VERFAHREN ZUR GALVANISCHEN ABFORMUNG VON MIT STRUKTUREN VERSEHENEN PLATTENFÖRMIGEN KÖRPERN**

PROCESS FOR GALVANICALLY FORMING STRUCTURED PLATE-SHAPED BODIES

PROCEDE DE FORMAGE PAR GALVANISATION DE CORPS STRUCTURES SE PRESENTANT SOUS FORME DE PLAQUES

(84) Benannte Vertragsstaaten:
**AT BE CH DE FR GB LI NL SE**

(30) Priorität: **23.09.1992 DE 4231742**

(43) Veröffentlichungstag der Anmeldung:
**12.07.1995 Patentblatt 1995/28**

(73) Patentinhaber:
- **Forschungszentrum Karlsruhe GmbH**
  **D-76133 Karlsruhe (DE)**
- **Bürkert GmbH**
  **D-74653 Ingelfingen (DE)**

(72) Erfinder:
- **DINGLREITER, Heinz**
  **D-76694 Forst (DE)**

- **KALB, Helmut**
  **D-74632 Neuenstein (DE)**
- **RAPP, Richard**
  **D-76297 Stutensee (DE)**

(74) Vertreter: **Gottlob, Peter, Dipl. Ing.**
**Forschungszentrum Karlsruhe GmbH**
**Stabsabteilung**
**Patente und Lizenzen**
**Weberstrasse 5**
**D-76133 Karlsruhe (DE)**

(56) Entgegenhaltungen:
**EP-A- 0 273 552        EP-A- 0 331 208**
**EP-A- 0 476 867        DE-A- 4 010 669**

**Beschreibung**

Die Erfindung betrifft ein Verfahren zur galvanischen Abformung von mit Strukturen versehenen plattenförmigen Körpern gemäß dem ersten Patentanspruch.

In der Mikrostrukturtechnik stellt sich häufig die Aufgabe, eine z. B. mit Hilfe der Mikroabformtechnik oder der Röntgentiefenlithographie erhaltene, mit Mikrostrukturkörpern versehene Kunststoffplatte mit Hilfe eines Metalls galvanisch abzuformen. Die Mikrostrukturkörper auf der Kunststoffplatte werden dabei in der Weise hergestellt, daß der Strukturgrund, d. h. die Fläche, auf der sich die Mikrostrukturkörper erheben, elektrisch leitend ist. Die einfachste Möglichkeit, eine solche elektrisch leitende Fläche zu schaffen, besteht darin, die Kunststoffplatte mit einer Metallplatte zu verbinden und bei der Mikrostrukturierung das an die Mikrostrukturkörper angrenzende Material bis auf die Metallplatte zu entfernen, so daß sich die Mikrostrukturkörper direkt auf der Metallplatte erheben und die freigelegten Flächen der Metallplatte den Strukturgrund bilden.

Die Mikrostrukturkörper können dann abgeformt werden, indem die Metallplatte in einem galvanischen Bad als Kathode eingesetzt wird. Hierbei füllen sich zuerst die Zwischenräume der Mikrostrukturkörper vom Strukturgrund aus. Bei Fortführung des galvanischen Prozesses werden die Mikrostrukturkörper schließlich durch seitliches Überwachsen der elektrisch nichtleitenden Stirnflächen mit dem Metall bedeckt; am Ende des Prozesses sind die Mikrostrukturkörper vollständig in das Metall eingebettet.

Ein solches Verfahren wird z. B. in der DE 40 01 399 C1 angesprochen.

Ein Verfahren zur galvanischen Abformung von mit Strukturen versehenen plattenförmigen Körpern geht aus der DE 40 10 669 C1 hervor. Das hier beschriebene Verfahren dient zur Herstellung von galvanisch abformbaren Negativformen mikrostrukturierter, plattenförmiger Körper, deren Strukturgrund eine zusammenhängende Fläche bildet und mit einer Schicht eines elektrisch leitenden Materials überzogen ist, wobei die Schicht des elektrisch leitenden Materials bei der nachfolgenden galvanischen Abformung als Kathode verwendet wird.

Das Verfahren geht von einer Thermoplast-Schicht aus, auf der ein Film eines elektrisch leitenden Materials aufgebracht wird. Ein mikrostrukturierter Formeinsatz wird durch den Film des elektrisch leitenden Materials hindurch in die Thermoplast-Schicht eingedrückt und danach wieder entfernt. Mit diesem Verfahren wird somit ein zusammenhängender, elektrisch leitender Strukturgrund geschaffen.

Beim Eindrücken des Formeinsatzes in die filmbeschichtete Thermoplast-Schicht reißt der Film an den mit Mikrostrukturen versehenen Stellen des Formeinsatzes auf. Nach dem Entfernen des Formeinsatzes bleiben auf den senkrechten Wänden und auf der Stirnseite der Mikrostrukturen kleine, gegeneinander isolierte, inselartige Flitter des Filmmaterials zurück. Im Strukturgrund der Negativform bleibt dagegen der Film unzerstört erhalten. Bezüglich der auf den Mikrostrukturen der Negativform zurückbleibenden Reste des Films wird erläutert, sie seien wegen ihrer inselartigen Anordnung gegen den Strukturgrund elektrisch isoliert und behinderten daher die exakte Galvanoabformung der Negativform nicht.

Der Zweck des Verfahrens besteht in der Ausbildung eines zusammenhängenden, elektrisch leitenden, vollständig mit dem Film des elektrisch leitenden Materials überdeckten Strukturgrunds. Die inselartigen Flitter des Films entstehen als Nebeneffekt und sind daher - abhängig von der Dicke des Films und von der Gestalt der Mikrostrukturen - zufällig und nicht reproduzierbar auf den Mikrostrukturen verteilt.

Gemäß dem Abstract zu JP Kokei No. 53-106 643 wird ein Kunststoffsubstrat mit Hilfe eines Abformwerkzeugs so strukturiert, daß konkave Vertiefungen und konvexe Strukturkörper erzeugt werden. Das Kunststoffsubstrat wird anschließend auf der gesamten Oberfläche mit einer dünnen Schicht eines elektrisch leitenden Materials überzogen. Danach werden nur diejenigen Teile des elektrisch leitenden Materials entfernt, die sich auf den Stirnflächen der konvexen Strukturkörper befinden. Danach werden die konkaven Vertiefungen galvanisch mit dem elektrisch leitenden Material aufgefüllt. Das über die Stirnflächen der konvexen Strukturkörper hinausragende elektrisch leitende Material wird entfernt. Da das galvanisch abgeschiedene Material und die konvexen Strukturkörper dieselbe Höhe haben sollen, ergeben sich keine Probleme durch das galvanische Überwachsen der Stirnflächen.

Gegenstand der DE 34 42 781 C2 ist ein Verfahren zur Herstellung einer Einstellscheibe für Kameras, bei dem auf der Oberfläche einer Metallplatte durch machanische Bearbeitung ein regelmäßiges Relief ausgebildet wird, das Relief einer Galvanisierbehandlung unterzogen wird, wobei dem Galvanisierbad eine Emulsion zugesetzt wird, die mit einer örtlichen und zeitlichen statistischen Verteilung die galvanische Abscheidung hemmt, und das sich ergebende Muster auf ein optisches Material abgeformt wird. Beim bekannten Verfahren wird somit auf der gesamten, mechanisch strukturierten Metallplatte galvanisch ein Metall abgeschieden. Sowohl der Strukturgrund als auch die Strukturkörper sind elektrisch leitend. Durch die Emulsion wird die galvanische Abscheidung an kleinen, statistisch verteilten Stellen gehemmt.

Die Veröffentlichung Pat. Abstr. of Japan, C-861, August 23, 1991, Vol. 15, No. 332 [Abstr. zu JP 3-126 887 (A)] beschreibt ein Verfahren, bei dem Metallpulver, z. B. Nickelpulver, einem flüssigen Harz beigemischt wird. Das Harz mit dem Metallpulver wird anschließend in eine Negativform gefüllt und ausgehärtet. Die Oberfläche des gehärteten Harzels wird geschliffen, so daß eine glatte Oberfläche entsteht, auf der das Pulver freigelegt ist. Die Gießform wird danach in eine Galvanikzelle verbracht; Nickel wird auf der Oberfläche der Form abgeschieden, um einen Hohlraum für eine Galvanikabscheidung zu schaffen. Bei diesem Verfahren muß die Form nicht direkt poliert werden. Da bei diesem Verfahren das Gießharz mit Metallpulver elektrisch leitfähig gemacht wird, müssen verhältnismäßig hohe Konzentrationen an Metallpulver angewendet werden, die die Eigenschaften des Gießharzes deutlich verändern.

Das Verfahren gemäß der DE-OS 16 21 034 betrifft ein Verfahren zur Herstellung einer Matrize für die galvanoplastische Herstellung von Siebblechen, Scherfolien, Filtern, Gittern oder dergleichen, wobei auf eine polierte und gereinigte Metallplatte eine lichtempfindliche Photokopierschicht aufgebracht und im gewünschten Muster belichtet wird, nach der Entwicklung die belichteten Stellen gehärtet und die unbelichteten abgelöst werden, sowie danach die Metallplatte an den freiliegenden Stellen zur Bildung von Vertiefungen geätzt wird. Gemäß dem bekannten Verfahren wird die mit geätzten Vertiefungen versehene Metallplatte, auf der die belichtete Photokopierschicht entfernt ist, mit einem härtbaren, elektrisch leitenden Kunststoff aufgefüllt und überzogen. Nach dem Aushärten werden die Metallplatte und die Schicht des elektrisch leitenden Kunststoffs getrennt. Die Schicht des elektrisch leitenden Kunststoffs und nicht die Metallplatte dienen der galvanischen Abformung.

Die Schicht des Kunststoffs ist an allen ihrer strukturierten Stellen elektrisch leitend. Das Verfahren befaßt sich nicht mit der galvanischen Abformung.

Die vorliegende Erfindung befaßt sich mit dem Problem des gleichmäßigen galvanischen Überwachsens einer elektrisch nicht leitenden Fläche, wie sie im eingangs angesprochenen Normalfall auf der Stirnfläche von Strukturkörpern aus einem Kunststoff vorliegt. Das galvanische Überwachsen der Stirnfläche der Strukturkörper beginnt an einem elektrisch leitenden Strukturgrund, der sich, wie eingangs erwähnt, allmählich füllt und schließlich die Mikrostrukturkörper überzieht und einbettet.

Bei diesem Galvanikschritt sind zwei verschiedene Prozesse zu unterscheiden: das Vertikalwachstum, bei dem sich die Ablagerung des galvanisch abzuscheidenden Metalls über einer elektrisch leitfähigen, als Kathode dienenden Metallschicht bzw. dem darauf bereits abgeschiedenen Metall vollzieht, und dem Querwachstum, das nach Erreichen der Stirnflächen der Mikrostrukturkörper einsetzt und diese schließlich mit Metall überzieht.

Die Geschwindigkeit des Querwachstums liegt bei den üblicherweise verwendeten Galvanikbedingungen (Nickelsulfamatelektrolyt, Stromdichte 1 A/dm$^2$) in der Größenordnung des Vertikalwachstums, d. h. bei ca. 12 µm/h. Während des Querwachstums ändert sich die zu galvanisierende Fläche ständig. Dies führt zu Unterschieden in den Schichteigenschaften, insbesondere in Bezug auf die Eigenspannung und die Härte, durch die sich ändernden Abscheidebedingungen, vor allem durch das Absinken der effektiven Stromdichte. Besonders bei Strukturkörpern mit ausgedehnten Stirnflächen ergeben sich durch das verlangsamte seitliche Überwachsen außerdem große Höhenunterschiede in der galvanisch abgeschiedenen Schicht. Beim Übergalvanisieren von gestuften Strukturkörpern kann es beim Aufeinandertreffen der galvanischen Wachstumsfronten sogar zu Fehlstellen in Höhe der mittleren und obersten Stirnflächen der Strukturkörper kommen.

An sich wäre der Gedanke naheliegend, die Stirnflächen der Strukturkörper mit einer ganzflächigen, gegenüber dem Strukturgrund elektrisch isolierten, leitfähigen Beschichtung zu versehen. Hierdurch könnte ein gegenüber dem Vertikalwachstum beschleunigtes Querwachstum erzielt werden. In diesem Fall würde in dem Augenblick, in dem das zwischen den Mikrostrukturkörpern aufwachsende Metall die Stirnflächen erreicht, eine schlagartige Kontaktierung der beschichteten Stirnflächen bewirkt. Da die metallische Abscheidung zwischen den Strukturkörpern jedoch strukturbedingt in der Regel ungleichmäßig schnell verläuft, kann eine schlagartige Kontaktierung dazu führen, daß das weitere Vertikalwachstum in Bereichen, wo die Stirnflächen der Strukturkörper noch nicht erreicht sind, durch galvanisches Querwachstum von den Stirnflächen aus unterbrochen wird. Dies macht sich dadurch bemerkbar, daß einzelne Strukturkörper nicht abgeformt werden und in dem galvanisch abgeschiedenen Metallkörper fehlen. An diesen Stellen entstehen im galvanisch abgeformten Produkt Hohlräume. Dieser Effekt wird umso ausgeprägter beobachtet, je größer das Aspektverhältnis (Verhältnis Höhe zu charakteristischer Breite) der Strukturkörper ist und je unterschiedlicher die Aspektverhältnisse der Strukturkörper untereinander sind.

Die Aufgabe der Erfindung besteht darin, ein Verfahren anzugeben, mit dessen Hilfe die geschilderten Probleme beim Querwachstum von galvanisch abgeschiedenem Metall zuverlässig beseitigt werden können.

Die Aufgabe wird durch das im ersten Patentanspruch beschriebene Verfahren gelöst. Die weiteren Patentansprüche geben besondere Ausgestaltungen des Verfahrens an.

Die Erfindung ist nicht auf Mikrostrukturen beschränkt. Das erfindungsgemäße Verfahren kann auch bei Strukturen im mm-Maßstab angewandt werden.

Ein wesentliches Merkmal des erfindungsgemäßen Verfahrens ist es, daß auf den Strukturkörpern ein Muster kleiner, gegeneinander elektrisch isolierter Inseln geschaffen wird. Die Größe der einzelnen Inseln hängt dabei von der Ausdehnung der Stirnflächen auf den Strukturkörpern ab. Der größte Durchmesser der einzelnen Inseln soll so bemessen werden, daß vor dem Galvanisieren auf den Stirnflächen in jeder Richtung mehrere einzelne Inseln vorliegen. Nimmt die Stirnfläche eines Strukturkörpers z. B. eine stegartige Form an, so muß der Durchmesser so bemessen sein, daß auch über die Stegbreite mindestens eine isolierte Insel Platz findet. Vor dem Galvanisieren müssen somit sämtliche Stirnflächen mit dem Muster der Inseln überzogen sein, wobei in jeder Richtung mindestens eine Insel vorhanden sein muß.

Prinzipiell kann dieses Muster sowohl vor der Strukturierung als auch danach erzeugt werden. In beiden Fällen läßt sich vor dem Galvanisierungsschritt dieselbe, oben beschriebene Anordnung herstellen. Geht man von einer Kunststoffschicht aus, die mit einer Schicht eines elektrisch leitenden Materials überzogen ist, so kann das Muster der Inseln bereits auf dieser Anordnung erzeugt werden, bevor die Strukturierung vorgenommen wird. Selbstverständlich sind bei der Wahl des Inseldurchmessers die geplanten Abmessungen der danach entstehenden Stirnflächen zu beachten. Ebenso kann das Muster der Inseln auf den bereits ausgeformten Stirnflächen der Strukturkörper angelegt werden.

Ein solches Muster kann nach dem Verfahren gemäß der eingangs diskutierten DE 40 10 669 C1 nicht erhalten werden, da hier die Inseln in nicht reproduzierbarer Art und in zufälliger Größenverteilung entstehen.

Beim erfindungsgemäßen Verfahren erfolgt das galvanische Überwachsen der Stirnflächen in der Weise, daß die einzelnen Inseln, ausgehend von einer oder mehreren Nachbarinsel, die durch das Vertikalwachstum bereits elektrisch kontaktiert sind, eine schrittweise galvanische Abscheidung bewirken. Da die Inseln selbst elektrisch leitend sind, bildet sich auf einer kontaktierten Insel ein metallischer Niederschlag, der anwächst und langsam den elektrisch isolierenden Bereich zwischen dieser Insel und der nächsten, noch nicht kontaktierten Insel überwächst. Sobald die metallische Abscheidung die nächste Insel erreicht, wird diese schlagartig kontaktiert und der Vorgang beginnt von neuem. Hierdurch wird das Querwachstum im Vergleich zum Vertikalwachstum beschleunigt.

Mit diesem Prinzip ist es möglich, die Geschwindigkeit des seitlichen Überwachsens nichtleitender Bereiche genau einzustellen. Geht man zum Beispiel von einer gleichmäßigen Anordnung der leitfähigen Inseln (Abstand: b) und einer stets identischen Inselgröße (charakteristische Abmessung bzw. Durchmesser: a) aus, dann ergibt sich für die Geschwindigkeit des Querwachstums:

$$V_{quer,beschichtet} = (a + b)/b \cdot V_{vertikal}$$

Dies gilt, wenn bei unbeschichteter, also nicht mit dem erfindungsgemäß hergestelltem Muster versehener Stirnfläche von gleicher Wachstumsgeschwindigkeit in alle Raumrichtungen ausgegangen werden darf, was in guter Näherung angenommen werden kann. Andernfalls gilt:

$$V_{quer, beschichtet} = (a + b)/b \cdot V_{quer, unbeschichtet}$$

Darüberhinaus kann durch gezielt eingestellte ungleichmäßige Anordnung der Inseln oder durch den gezielten Einsatz von größeren Inseln die Geschwindigkeit des seitlichen Überwachsens auf besondere Anforderungen eines Designs angepaßt werden; das erfindungsgemäße Verfahren ist also gemäß den gestellten Anforderungen abwandelbar und flexibel einsetzbar.

Inselgeometrie, Inselgröße, Inselabstand und die Dicke der Inseln (und damit die Dicke der Schicht des elektrisch leitenden Materials) sind nahezu beliebig wählbar und nur durch die zur Herstellung der Inselstrukturen zu beachtenden Verfahrensgrenzen beschränkt. Die Dicke der Inseln kann (in Übereinstimmung mit den Angaben in der eingangs diskutierten DE 40 10 669 C1) etwa 10 bis 10000 nm, vorzugsweise ca. 50 bis 300 nm, betragen. Typische Abmessungen für den Inselabstand sind z. B. 1 bis 10 µm und für die Inselgröße 5 bis 50 µm. Durch die Wahl einer günstigen Inselgeometrie, z. B: Rahmen- oder Ringform, läßt sich zudem die beschichtete Fläche auf ein Minimum begrenzen. Es spielt beispielsweise für di das galvanische Querwachstum beschleunigende Wirkung keine Rolle, ob mit leitfähigen Inseln gearbeitet wird, die innerhalb ihrer Außenkontur vollständig elektrisch leitend sind, oder bei denen nur ein Randbereich entlang der Außenkontur elektrisch leitend ist, das Inselinnere aber nichtleitend ist.

Für die Strukturierung der mit einer durchgehenden Schicht des elektrisch leitenden Materials oder mit einem Muster der Inseln überzogenen Kunststoffschicht gibt es mindestens zwei Möglichkeiten: die Abformtechnik, wobei z. B. gemäß der eingangs diskutierten DE 40 10 669 C1 ein mikrostrukturiertes plattenförmiges Werkzeug abgeformt wird, oder die optische bzw. Röntgentiefenlithographie. Em ersten Fall muß als Kunststoff ein Kunststoff mit thermoplastischen Eigenschaften verwendet werden. Im zweiten Fall besteht der Kunststoff aus einem der bekannten optischen oder Röntgenresistmaterialien, etwa aus Polymethylmethacrylat (PMMA), oder einem PIQ-Lack.

In beiden Fällen muß die Mikrostrukturierung in der Weise durchgeführt werden, daß der Strukturgrund eine zusammenhängende, elektrisch leitende Fläche darstellt, die im Galvanikbad als Kathode geschaltet werden kann. Bei der Abformtechnik kann der Strukturgrund durch Prägen einer Verbundschicht aus einem Thermoplast und einer darauf angebrachten elektrisch leitfähigen Schicht (z. B. Metall- oder Rußschicht) elektrisch leitend gemacht werden. Hierbei besteht jedoch eine Einschränkung hinsichtlich der Formgebung: der Strukturgrund muß insgesamt eine zusammenhängende Fläche darstellen. Für die Röntgentiefenlithographie kann von einer metallische Grundplatte mit aufpolymerisiertem Röntgenresist ausgegangen werden. Hier bestehen keine Einschränkungen hinsichtlich der Formgebung, da die metallische Grundplatte in allen Fällen einen zusammenhängenden Strukturgrund bildet.

Für die Herstellung des Musters kleiner, elektrisch gegeneinander isolierter Inseln gibt es zumindest drei Verfahren A, B und C, die im folgenden anhand von Figuren näher erläutert werden.

Es stellen dar:

**Fig. 1** Verfahrensvariante A;
**Fig. 2** Verfahrensvariante B;
**Fig. 3** Verfahrensvariante C.

Die Verfahrensvarianten werden am Beispiel einer röntgentiefenlithographischen Mikrostrukturierung erläutert, wobei die Kunststoffschicht (hier: die Schicht des Röntgenresistmaterials) vor der Mikrostrukturierung mit der Schicht des elektrisch leitenden Materials überzogen wird. Erst danach erfolgt die röntgentiefenlithographische Mikrostrukturierung. Der Vorteil dieser Verfahrensführung besteht darin, daß gewährleistet ist, daß tatsächlich nur die Stirnflächen der Mikrostrukturkörper beschichtet werden, nicht jedoch die senkrechten Seitenwände der Mikrostrukturkörper. Beim nachfolgenden Galvanisieren werden zunächst nur die Zwischenräume zwischen den Mikrostrukturkörpern ausgehend vom elektrisch leitenden Strukturgrund aufgefüllt. Sobald die galvanische Abscheidung die Stirnflächen der Mikrostrukturkörper erreicht, werden die Inseln der leitfähigen Beschichtung nacheinander durch Querwachtum der Metallabscheidung kontaktiert und beschleunigen so das seitliche Überwachsen auf den Stirnflächen. Da jedoch keine schlagartige Kontaktierung der gesamten Stirnfläche eintritt, werden die eingangs beschriebenen Fehler vermieden.

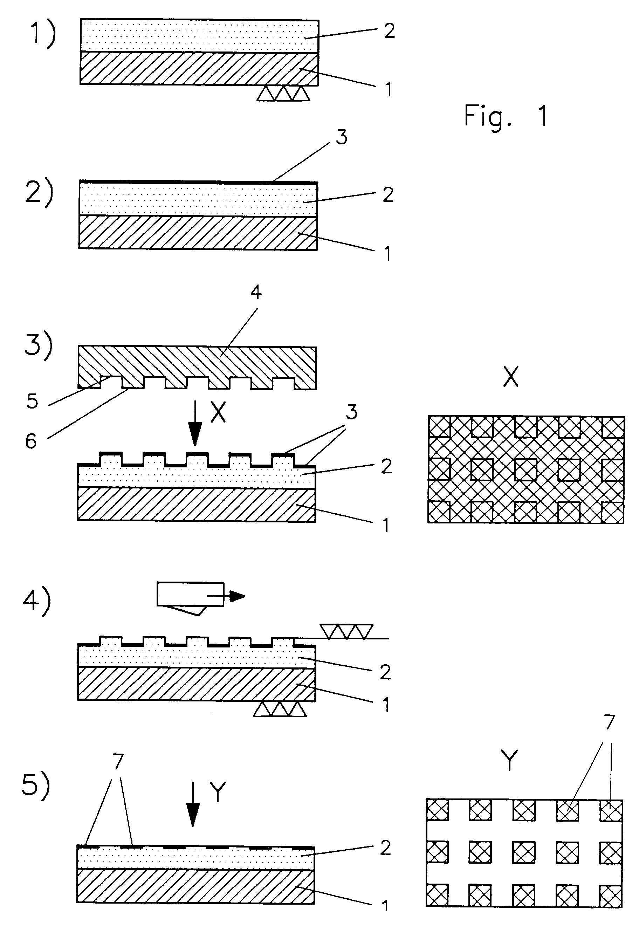

Fig. 1 zeigt die strukturierte Beschichtung durch Mikrostrukturabformung und mechanische Nachbearbeitung gemäß Verfahrensvariante A.

Auf eine beidseitig plan vorgearbeitete metallische Grundplatte (Formeinsatzgrundplatte) 1 wird eine ebene Röntgenresistschicht aus PMMA 2 aufpolymerisiert. [Fig. 1 Teil 1)].

Auf die Oberfläche der Röntgenresistschicht wird dan ganzflächig eine dünne (ca. 50 nm) Schicht 3 des elektrisch leitenden Materials aufgetragen [Fig. 1 Teil 2)]. Als leitende Beschichtungswerkstoffe kommen z. B. Gold, Kohlenstoff oder dünne leitfähig modifizierte Kunststoffschichten in Frage. Geeignete Beschichtungsverfahren zum Aufbringen dieser Schicht sind z. B. Abstäuben (Sputtern) oder Aufdampfen.

Im Vakuumprägeverfahren wird ein Metallstempel (Formeinsatz) 4 in die elektrisch leitende Schicht 3 eingedrückt [Fig. 1 Teil 3)]. Neben dem Vakuumprägeverfahren sind auch andere Abformverfahren wie z. B. das Reaktionsgießverfahren einsetzbar. Der Metallstempel 4 ist selbst entsprechend den Designanforderungen an die spätere Mikrostrukturierung mikrostrukturiert. In den meisten Fällen wird ein Metallstempel 4 zur Strukturierung der elektrisch leitenden Schicht 3 verwendet, der im Formgrund 5 eine zusammenhängende Fläche bildet, aus der voneinander isolierte Mikrostrukturen 6 vorstehen. Die Höhen der Mikrostrukturen 6 spielen im Prinzip keine Rolle; sie sollten jedoch im Interesse einer schnelleren mechanischen Nachbearbeitung nicht zu groß sein (ca. 2 bis 5 µm). Eine geringe Mikrostrukturhöhe ist außerdem vorzuziehen, da dann der Metallstempel 4 leicht durch optische Lithographie hergestellt werden kann. Als besonders günstig erweisen sich Metallstempel mit Pyramidenstrukturen, wie sie mit Methoden der mechanischen Mikrofertigung erhalten werden können. Solche Strukturen bieten die Möglichkeit, später durch die Wahl der Bearbeitungstiefe die Breite der elektrisch isolierenden Stege zwischen den leitfähigen Inseln zu variieren.

Durch die Mikrostrukturierung im Vakuumprägeverfahren wird ein vorstehendes Netzwerk auf der Oberfläche des Röntgenresists erhalten. Dieses Netzwerk wird samt der darüberliegenden Beschichtung durch eine mechanische Bearbeitung soweit abgetragen [Fig. 1 Teil 4)], bis nur noch elektrisch leitende, voneinander elektrisch isolierte Inseln 7 definierter Größe in den Zwischenräumen des Netzwerks vorliegen [Fig. 1 Teil 5)].

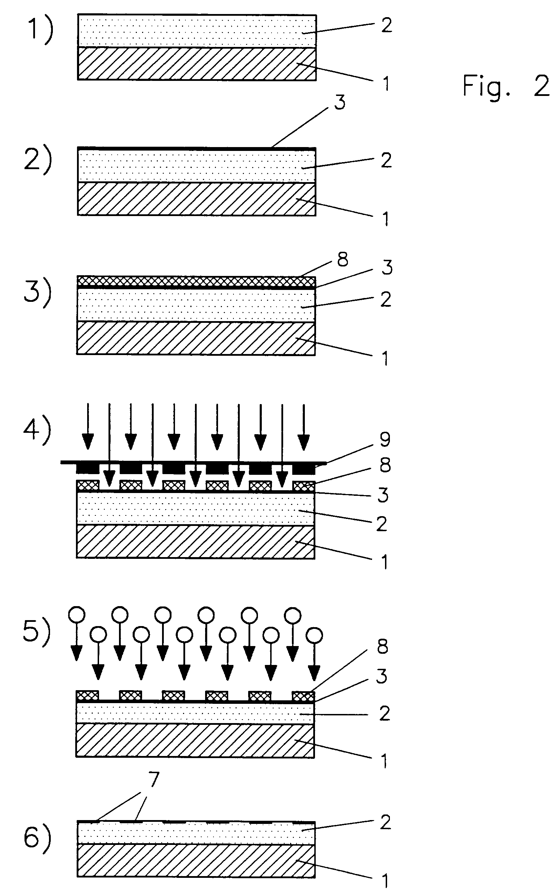

Fig. 2 zeigt ein subtraktives Mikrostrukturierungsverfahren gemäß der Verfahrensvariante B.

Wiederum ausgehend von einer Formeinsatzgrundplatte 1 wird eine Röntgenresistschicht 2 aus PMMA auf der Grundplatte aufpolymerisiert [Fig. 2 Teil 1)]. Darauf wird eine dünne, elektrisch leitfähige Schicht 3 aufgebracht [Fig. 2 Teil. 2)].

Anschließend wird ein lichtempfindlicher Photolack 8 auf die Oberfläche der elektrisch leitenden Schicht 3 aufgebracht. Die Dicke des Photolacks hängt von der erforderlichen Strukturierungsgenauigkeit ab und ist in der Regel sehr dünn (0,5 µm) [Fig. 2 Teil 3)].

Danach strukturiert man die Schicht des Photolacks 8 mit einem lithographischen Verfahren durch eine geeignete Maskierung 9 (z. B. Chrommaske) wie in Fig. 2 Teil 4) gezeigt.

Die freigelegte leitende Schicht 3 wird durch geeignete Ätzverfahren abgetragen. Hier sind isotrope oder anisotrope, chemische oder physikalische Abtragsverfahren möglich, wie z. B. naßchemisches Ätzen, Plasmaätzen oder Reaktives Ionenätzen [Fig. 2 Teil 5)].

Nach der Strukturierung der leitfähigen Schicht 3 wird der Photolack 8 entfernt. Die darunter liegenden elektrisch leitenden Bereiche bilden wie in Fig. 2 Teil 6) gezeigt voneinander elektrisch isolierte, selbst aber leitfähige Inseln 7.

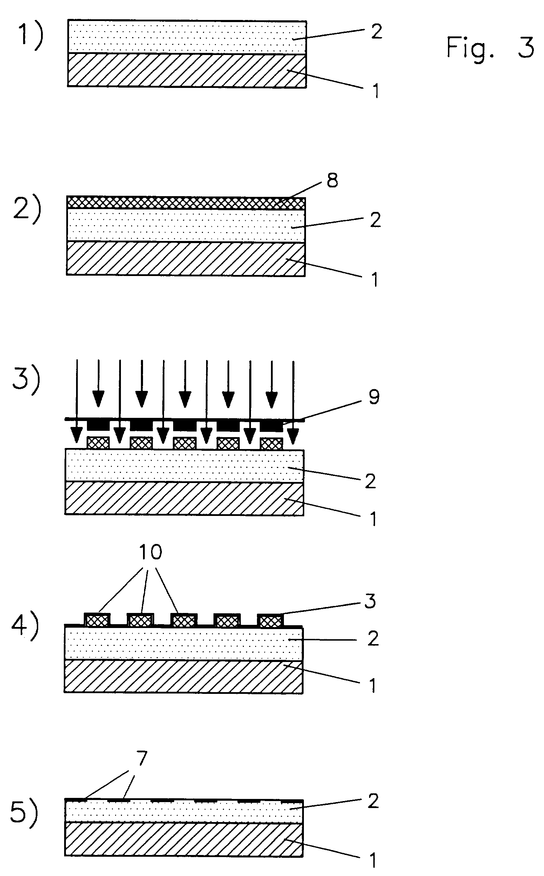

Fig. 3 zeigt ein additives Strukturierungsverfahren gemäß Verfahrensvariante C.

Auf eine Formeinsatzgrundplatte 1 mit einem aufpolymerisierten Röntgenresist 2 [Fig. 3 Teil 1)] wird ein lichtempfindlicher Photolack 8 aufgetragen [Fig. 3 Teil 2)] und mit lithographischen Strukturierungsverfahren mit Hilfe einer Maske 9 bearbeitet [Fig. 3 Teil 3)].

Im Gegensatz zu Verfahrensvariante B wird erst jetzt, nach der Strukturierung des Photolacks 8, eine elektrisch leitende Schicht 3 großflächig aufgetragen [Fig. 3 Teil 4)].

Danach wird der Photolack 8 entfernt. Dadurch werden auch die Bereiche 10 der elektrisch leitenden Schicht 3 abgetragen, die die Strukturen des Photolacks 8 bedecken. Die verbleibenden elektrisch leitfähigen Bereiche bilden wie bei den Verfahrensvarianten A und B voneinander elektrisch isolierte Inseln 7 [Fig. 3 Teil 5)].

Die Vorteile des erfindungsgemäßen Verfahrens können wie folgt zusammengefaßt werden:

Indem ein Muster elektrisch voneinander isolierter, an sich jedoch elektrisch leitender Inseln auf den Stirnflächen von Mikrostrukturkörpern angebracht wird, bevor die Mikrostrukturkörper durch Galvanisieren metallisch abgeformt werden, ist es möglich, die Geschwindigkeit des Querwachstums bei der galvanischen Metallabscheidung in weiten Grenzen frei einzustellen und an Designanforderungen anzupassen. Für die Herstellung von Formeinsätzen nach dem LIGA (Röntgentiefenlithographie und galvanische Abformung) - Verfahren bedeutet dies:

- fehlende Mikrostrukturelemente im galvanisch abgeformten Metall, die durch frühzeitige Kontaktierung einer ganzflächig beschichteten Reststirnfläche verursacht werden, werden vermieden, da die Stirnfläche nich schlagartig vollständig kontaktiert ist;
- Fehlstellen, die ohne das erfindungsgemäße Verfahren insbesondere bei der galvanischen Abformung von gestuften Mikrostrukturkörpern auftreten, werden ausgeschlossen;
- beim galvanischen Überwachsen von nichtleitenden Stirnflächen auftretende starke und schlecht kontrollierbare Änderungen in den Abscheidebedingungen (Stromdichte) werden beherrschbar. Der Oberflächenzuwachs beim Querwachstum und damit die Änderung der Stromdichte bei der Metallabscheidung kann besser vorausberechnet werden. Größere Höhenunterschiede in der galvanischen Abscheidung werden vermieden. Die mechanischen Eigenschaften wie z. B. die innere Spannung der abgeschiedenen Schichten können besser beinflußt werden und sind gleichmäßiger.

Die Erfindung wird im folgenden anhand von Ausführungsbeispielen näher erläutert.

Auf einer metallischen Grundplatte wurde eine Röntgenresistschicht aus PMMA aufgebracht und anschließend ganzflächig mit einer ca. 50 nm dicken Goldschicht besputtert. Im Vakuumprägeverfahren wurde in diese Schicht ein Metallstempel bei Prägetemperaturen um 160 °C, Prägezeiten um 5 min., Prägekräften um 10 kN eingepreßt und bei Entformtemperaturen um 90 °C entformt. Dadurch wurde auf der Resistschicht eine vorstehende Wabennetzstruktur erzeugt, die bei einer Schlüsselweite der Waben von ca. 20 μm eine Stegbreite von ca. 4 μm aufwies. Die Gesamthöhe der Wabennetzstruktur betrug ca. 4,3 μm.

Durch Abschleifen des vorstehenden Wabennetzes (Körnung 1200, naß) wurden die Wabenstege bis in den Strukturgrund abgetragen, so daß wieder eine nahezu ebene Resistoberfläche erreicht wurde, in der sich jetzt wabenförmige Goldinseln mit Schlüsselweite 20 μm befanden, welche durch 4 μm breite, isolierende Resistoberfläche voneinander getrennt wurden.

Um mögliche noch vorhandene Reste des Wabennetzes nachträglich einzuebnen, wurde in einem erneuten Vakuumprägeschritt bei den oben beschriebenen Bedingungen die Resistoberfläche gegen eine ebene Platte gepreßt (Verfahren nach Variante A).

Die Geschwindigkeit des Querwachstums bei der galvanischen Abscheidung wurde mit der auf diese Weise vorbehandelten Resistoberfläche gemessen, ohne daß zuvor eine Mikrostrukturierung stattgefunden hätte. Bei diesem Versuch wurde eine extrem ausgedehnte Stirnfläche eines "Mikrostrukturkörpers" simuliert.

Die Geschwindigkeit des Querwachstums wurde überprüft, indem die Probe in einem Nickelsulfamat-Elektrolyten, wie er üblicherweise zur Galvanisierung eingesetzt wird, bei einer Stromdichte von 1 A/dm$^2$ galvanisch mit Nickel überdeckt wurde. Anschließend wurde das Oberflächenprofil der abgeschiedenen Nickelschicht an mehreren Stellen vermessen. Aus dem Verhältnis von Querwachstum zu Vertikalwachstum über der Kontaktfläche wurde das Verhältnis der beiden Wachstumsgeschwindigkeiten bestimmt.

Nach der oben angeführten Gleichung war bei der vorliegenden Geometrie mit einem um etwa den Faktor 5,3 gegenüber dem Vertikalwachstum schnelleren Querwachstum zu rechnen. Das oben beschriebene Meßverfahren ergab demgegenüber im Mittel einen Faktor von 4,9 bei einer Standardabweichung von 0,24.

Das Höhenprofil der galvanischen Abscheidung zeigte dabei einen weitgehend linear in Richtung des Querwachstums abfallenden Verlauf. Dieses Ergebnis konnte in mehreren weiteren Versuchen reproduziert werden.

Darüber hinaus wurde eine Resistschicht (PMMA, ca. 200 μm dick) auf einer Formeinsatzgrundplatte (Cu) aufpolymerisiert und analog zu dem obigen Ausführungsbeispiel inselförmig beschichtet. Die so vorbehandelte Probe wurde dann in einem Röntgentiefenlithographie-Schritt durch eine Röntgenmaske mit Synchrotronstrahlung bestrahlt. Die bestrahlten Bereiche wurden in einem Entwicklerbad herausgelöst, so daß als Produkt eine metallische Grundplatte, auf der sich Kunststoffmikrostrukturen erheben, deren Stirnfläche mit einzelnen leitfähigen, voneinander isolierten Inseln versehen sind, erhalten wurde. Ausgehend von dieser Grundplatte wurde in einem folgenden Galvanikschritt (Nickelsulfamat-Elektrolyt, 1A/dm$^2$) so lange Metall abgeschieden, bis die Mikrostrukturen vollständig mit Metall überzogen waren. Es zeigte sich, daß die Stirnflächen erheblich schneller mit Metall überzogen waren, und daß dadurch die Höhenunterschiede der galvanischen Abscheidung weit geringer waren als vorausgegangene Versuche mit unbeschichteten Proben gezeigt hatten. Die Stirnflächen der Mikrostrukturen waren stellenweise über 1 mm breit.

**Patentansprüche**

1. Verfahren zur galvanischen Abformung von mit Strukturen versehenen plattenförmigen Körpern, bei dem

   a) eine Kunststoffschicht hergestellt wird,
   b) die Kunststoffschicht auf einer ihrer Seiten einer Strukturierung unterzogen wird, so daß Strukturkörper mit ebenen Stirnflächen geschaffen werden,
   c) die Strukturierung in der Weise durchgeführt wird, daß sich die Strukturkörper auf einem Strukturgrund erheben, der eine zusammenhängende, elektrisch leitende Fläche darstellt, und die Stirnflächen parallel zum Strukturgrund verlaufen,
   d) der Strukturgrund und die Strukturkörper galvanisch mit einem Metall überdeckt werden,

   wobei

   e) entweder

   - vor Durchführung der Strukturierung die Kunststoffschicht auf der zu strukturierenden Seite

   oder

   - die Stirnflächen der nach der Strukturierung erhaltenen Strukturkörper

   mit einem Muster kleiner, elektrisch leitender, jedoch elektrisch gegeneinander isolierter Inseln versehen werden, deren größter Durchmesser und deren gegenseitiger Abstand so gewählt wird, daß die Stirnflächen der durch die Strukturierung geschaffenen Strukturkörper in einem beliebigen Querschnitt mindestens eine Insel aufweisen.

2. Verfahren nach Anspruch 1, dadurch gekennzeichnet, daß die Kunststoffschicht aus einem Thermoplast hergestellt wird.

3. Verfahren nach Anspruch 2, dadurch gekennzeichnet, daß die Strukturierung durch Abformen eines strukturierten plattenförmigen Werkzeugs erfolgt.

4. Verfahren nach Anspruch 1, dadurch gekennzeichnet, daß die Kunststoffschicht aus einem Röntgenresistmaterial hergestellt wird.

5. Verfahren nach Anspruch 4, dadurch gekennzeichnet, daß die Strukturierung durch Röntgentiefenlithographie erzeugt wird.

6. Verfahren nach einem der Ansprüche 1 bis 5, dadurch gekennzeichnet, daß die Stirnflächen der durch die Strukturierung geschaffenen Strukturkörper in folgender Weise mit der Vielzahl der kleinen, elektrisch gegeneinander isolierten Inseln versehen werden:

   - Auftragen einer Schicht eines elektrisch leitenden Materials auf der zu strukturierenden Seite der Kunststoffschicht,

   - vertikales Eindrücken eines strukturierten Metallstempels in die Schicht des elektrisch leitenden Materials in der Weise, daß die Schicht des elektrisch leitenden Materials in eine oberflächliche Teilschicht und in eine tiefer liegende Teilschicht getrennt ist,
   - planes Abtragen der oberflächlichen Teilschicht, bis nur noch die tiefere Teilschicht bestehen bleibt.

7. Verfahren nach einem der Ansprüche 1 bis 5, dadurch gekennzeichnet, daß die Stirnflächen der durch die Strukturierung geschaffenen Strukturkörper in folgender Weise mit der Vielzahl der kleinen, elektrisch gegeneinander isolierten Inseln versehen werden:

   - Auftragen einer Schicht eines elektrisch leitenden Materials auf der zu strukturierenden Seite der Kunststoffschicht,

   - Auftragen einer Schicht eines lichtempfindlichen Photolacks auf der Schicht des elektrisch leitenden Materials,
   - partielles Bestrahlen der Schicht des licht-empfindlichen Photolacks durch eine Mas-ke, die für Licht durchlässige und für Licht undurchlässige Bereiche enthält,
   - Entfernen der bestrahlten Teile der Schicht des lichtempfindlichen Photolacks und der darunter liegenden Schicht des elektrisch leitenden Materials,
   - Entfernen der nicht bestrahlten Teile der Schicht des lichtempfindlichen Photolacks.

8. Verfahren nach einem der Ansprüche 1 bis 5, dadurch gekennzeichnet, daß die Stirnflächen der durch die Strukturierung geschaffenen Strukturkörper in folgender Weise mit der Vielzahl der kleinen, elektrisch gegeneinander isolierten Inseln versehen werden:

   - Überdecken der zu strukturierenden Seite der Kunststoffschicht mit einer Schicht eines lichtempfindlichen Photolacks,
   - partielles Bestrahlen der Schicht des lichtempfindlichen Photolacks durch eine Maske, die für Licht durchlässige und für Licht undurchlässige Bereiche enthält,

- Entfernen der bestrahlten Teile der Schicht des lichtempfindlichen Photolacks,
- Überziehen der auf diese Weise vorbehandelten Schicht des lichtempfindlichen Photolacks mit einer Schicht eines elektrisch leitenden Materials,
- Entfernen der nicht bestrahlten Teile der Schicht des lichtempfindlichen Photolacks zusammen mit den sie bedeckenden Teilen der Schicht des elektrisch leitenden Materials.

## Claims

1. Method of galvanically forming plate-like bodies, which are provided with structures, wherein

   a) a plastics material layer is produced,
   b) the plastics material layer is subjected to a structuring process on one of its sides, so that structural bodies with flat end faces are created,
   c) the structuring process is effected in such a manner that the structural bodies are raised on a structural base which represents a continuous, electrically conducting face, and the end faces extend parallel to the structural base,
   d) the structural base and the structural bodies are electroplated with a metal,
   wherein
   e) either

   - the plastics material layer on the side to be structured, prior to the structuring process being effected, is provided
          or
   - the end faces of the structural bodies, obtained after the structuring process, are provided

   with a pattern of small, electrically conducting islands, which are, however, electrically insulated from one another, the greatest diameter of said islands and the mutual spacing between said islands being selected so that the end faces of the structural bodies created by the structuring process have at least one island in any desirable cross-section.

2. Method according to claim 1, characterised in that the plastics material layer is produced from a thermoplastic material.

3. Method according to claim 2, characterised in that the structuring process is effected by forming a structured, plate-like tool.

4. Method according to claim 1, characterised in that the plastics material layer is produced from an X-ray resist material.

5. Method according to claim 4, characterised in that the structuring process is produced by deep X-ray lithography.

6. Method according to one of claims 1 to 5, characterised in that the end faces of the structural bodies created by the structuring process are provided in the following manner with the plurality of small islands which are electrically insulated from one another:

   - a layer of an electrically conducting material is applied to the side of the plastics material layer to be structured,
   - a structured metal punch is urged vertically into the layer of the electrically conducting material in such a manner that the layer of the electrically conducting material is separated into a superficial partial layer and into a partial layer situated lower down, and
   - the superficial partial layer is removed in a planar manner until only the lower partial layer still remains.

7. Method according to one of claims 1 to 5, characterised in that the end faces of the structural bodies created by the structuring process are provided in the following manner with the plurality of small islands which are electrically insulated from one another:

   - a layer of an electrically conducting material is applied to the side of the plastics material layer to be structured,
   - a layer of a light-sensitive photoresist is applied to the layer of the electrically conducting material,
   - the layer of the light-sensitive photoresist is partially irradiated by a mask, which contains regions which are permeable to light and impermeable to light,
   - the irradiated portions of the layer of the light-sensitive photoresist and the layer of the electrically conducting material situated therebeneath are removed, and
   - the non-irradiated portions of the layer of the light-sensitive photoresist are removed.

8. Method according to one of claims 1 to 5, characterised in that the end faces of the structural bodies created by the structuring process are provided in the following manner with the plurality of small islands which are electrically insulated from one another:

- the side of the plastics material layer to be structured is covered with a layer of a light-sensitive photoresist,
- the layer of the light-sensitive photoresist is partially irradiated by a mask, which contains regions which are permeable to light and impermeable to light,
- the irradiated portions of the layer of the light-sensitive photoresist are removed,
- the layer of the light-sensitive photoresist, which has been pretreated in this manner, is covered with a layer of an electrically conducting material, and
- the non-irradiated portions of the layer of the light-sensitive photoresist are removed, together with the portions of the layer of the electrically conducting material covering them.

## Revendications

1. Procédé pour le formage galvanoplastique de corps en forme de plaque munis de structures, dans lequel :

   a) on produit une couche de matière plastique,
   b) la couche de matière plastique est soumise sur une de ses faces à une structuration, de sorte que des corps de structure sont créés avec des surfaces frontales planes,
   c) la structuration est réalisée de manière que les corps de structure s'élèvent sur une base de structure, qui présente une surface électriquement conductrice, continue et les faces frontales se développent parallèlement à la base de structure,
   d) la base de structure et les corps de structure sont recouverts par galvanoplastie d'un métal, caractérisé en ce que :
   e) soit

   - avant la réalisation de la structuration la couche de matière plastique sur le côté à structurer,
   - les faces frontales des corps de structure obtenus après la structuration

   sont munies d'un modèle d'îles petites, électriquement conductrices, toutefois isolées électriquement les unes des autres, dont le diamètre le plus grand et dont la distance réciproque sont choisis, pour que les surfaces frontales des corps de structure créés par la structuration comportent dans une section transversale quelconque au moins une île.

2. Procédé selon la revendication 1, caractérisé en ce que la couche de matière plastique est produite dans une matière thermoplastique.

3. Procédé selon la revendication 2, caractérisé en ce que la structuration a lieu par formage d'un instrument structuré en forme de plaque.

4. Procédé selon la revendication 1, caractérisé en ce que la couche de matière plastique est produite en un matériau résistant aux rayons X.

5. Procédé selon la revendication 4, caractérisé en ce que la structuration est obtenue par lithographie en profondeur aux rayons X.

6. Procédé selon une des revendications 1 à 5, caractérisé en ce que les faces frontales des corps de structure créés par la structuration sont munies d'un grand nombre de petites îles, électriquement isolées les unes des autres de la manière suivante :

   - application d'une couche d'un matériau électriquement conducteur sur la face à structures de la couche de matière plastique,
   - enfoncement vertical d'un poinçon métallique structuré dans la couche du matériau électriquement conducteur, de manière que la couche du matériau électriquement conducteur soit divisée en une couche partielle superficielle et en une couche partielle située plus profondément,
   - enlèvement plan de la couche partielle superficielle jusqu'à ce qu'il ne subsiste plus que la couche partielle plus profonde .

7. Procédé selon une des revendications 1 à 5, caractérisé en ce que les faces frontales des corps de structure créés par la structuration sont munies du grand nombre des petites îles, isolées électriquement les unes envers les autres de la manière suivante :

   - application d'une couche d'un matériau électriquement conducteur sur la face à structures de la couche de matière plastique,
   - application d'une couche d'une photolaque sensible à la lumière sur la couche du matériau électriquement conducteur,
   - irradiation partielle de la couche de la photolaque sensible à la lumière à travers un cache, qui contient des zones transparentes à la lumière et non transparentes à la lumière,
   - enlèvement des parties irradiées de la couche de la photolaque sensible à la lumière et de la couche située en-dessous du matériau électriquement conducteur,
   - enlèvement des parties non irradiées de la couche de la photolaque sensible à la lumière.

8. Procédé selon une des revendications 1 à 5, caractérisé en ce que les faces frontales des corps de structure créés par la structuration sont munies du grand nombre des petites îles électriquement isolées les unes par rapport aux autres de la manière suivante :

- recouvrement de la partie à structurer de la couche de matière plastique avec une couche d'une photolaque sensible à la lumière,
- irradiation partielle de la couche de photolaque sensible à la lumière à travers un cache, qui contient des zones transparentes à la lumière et non transparentes à la lumière,
- enlèvement des parties irradiées de la couche de photolaque sensible à la lumière,
- revêtement de la couche de photolaque sensible à la lumière prétraitée de cette manière avec une couche d'un matériau électriquement conducteur,
- enlèvement des parties non irradiées de la couche de la photolaque sensible à la lumière ensemble avec les parties les recouvrant de la couche du matériau électriquement conducteur.

Fig. 1

Fig. 2

Fig. 3